Europäisches Patentamt

European Patent Office

Office européen des brevets

(11) Numéro de publication : **0 441 294 B1**

## (12) FASCICULE DE BREVET EUROPEEN

(45) Date de publication du fascicule du brevet :
**12.07.95 Bulletin 95/28**

(51) Int. Cl.$^6$ : **H01C 7/00**

(21) Numéro de dépôt : **91101457.9**

(22) Date de dépôt : **04.02.91**

(54) **Resistance pour circuit hybride, notamment de puissance.**

(30) Priorité : **09.02.90 FR 9001533**

(43) Date de publication de la demande :
**14.08.91 Bulletin 91/33**

(45) Mention de la délivrance du brevet :
**12.07.95 Bulletin 95/28**

(84) Etats contractants désignés :
**DE FR GB IT**

(56) Documents cités :
**EP-A- 0 208 808**
**US-A- 4 331 949**
**US-A- 4 613 844**

(56) Documents cités :
**SOLID STATE TECHNOLOGY vol. 20, no. 10, octobre 1977, WASHINGTON (US) pages 59-62; W. E. COUNTS: "RESISTOR STABILITY AND POWER DISSIPATION"**

(73) Titulaire : **GEC ALSTHOM SA**
**38, avenue Kléber**
**F-75116 Paris (FR)**

(72) Inventeur : **Chave, Jacques**
**56, rue Jeanne d'Arc**
**F-69003 Lyon (FR)**

(74) Mandataire : **Weinmiller, Jürgen et al**
**Lennéstrasse 9**
**Postfach 24**
**D-82336 Feldafing (DE)**

## Description

La présente invention concerne la réalisation de résistances en technologie hybride, plus particulièrement en technologie hybride de puissance.

Les résistances utilisées dans les circuits hybrides de puissance ont le plus souvent des valeurs ohmiques faibles (inférieures ou égales à 1 Ohm) et doivent supporter des courants de quelques Ampères à quelques dizaines d'Ampères.

En technologie hybride, les résistances sont obtenues classiquement par sérigraphie d'une matière résistive sur le substrat d'un circuit hybride, suivant des motifs dont la forme est en général dictée par des contraintes d'implantation sur le circuit hybride.

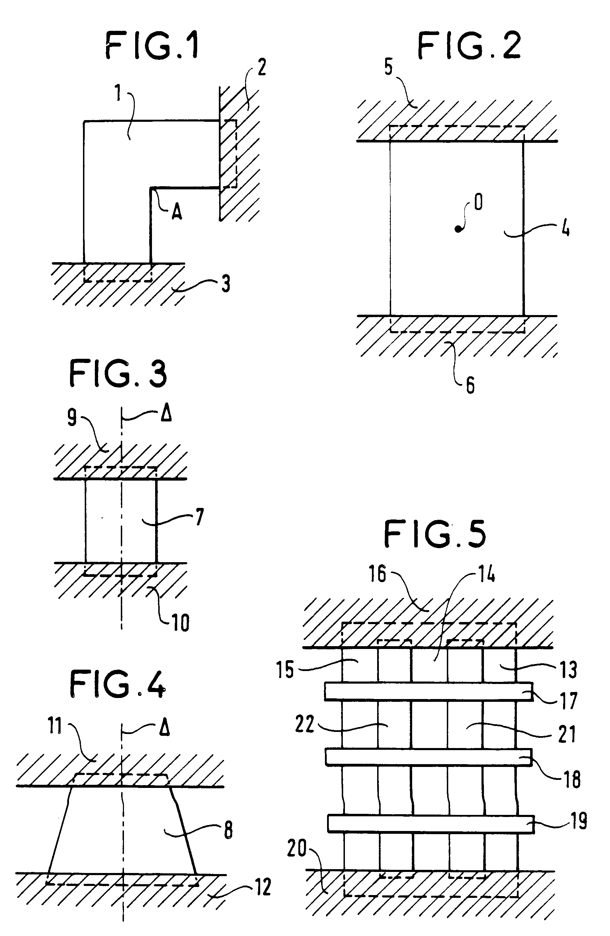

Certains motifs utilisés jusqu'à présent, tels que ceux représentés sur les figures 1 et 2, présentent, dans le cas de circuits hybrides de puissance, un risque d'accumulation d'énergie en certains points de ces résistances, dits points chauds, et par conséquent un risque de détérioration de ces résistances.

Cela est le cas du point repéré A sur la figure 1, correspondant à un angle vif d'une résistance 1 s'appuyant sur deux attaches conductrices 2 et 3.

Cela est aussi le cas au centre 0 de la résistance 4 représentée sur la figure 2, s'appuyant sur deux attaches conductrices 5 et 6, et présentant une surface relativement importante.

Dans le premier cas la formation d'un point chaud est due à une concentration de lignes de courant dans une zone de moindre résistivité (le trajet des lignes de courant étant en effet le plus court au point A).

Dans le deuxième cas, où les lignes de courant sont toutes parallèles entre elles et de longueur égale, la formation d'un point chaud est dûe au fait que le résultat de l'intégration de la densité de lignes de courant est plus élevé au centre qu'en bordure de la résistance.

La présente invention telle que définie par la revendication unique permet d'éviter ces inconvénients.

Les objets et caractéristiques de la présente invention apparaîtront plus clairement à la lecture de la description suivante d'exemples de réalisation, faite en relation avec les dessins ci-annexés dans lesquels, outre les figures 1 et 2 déjà décrites :

- les figures 3 et 4 montrent à titre d'exemple diverses formes de résistances;
- la figure 5 montre à titre d'exemple une forme de résistance selon l'invention.

Lorsque la puissance électrique dissipée par une résistance est suffisamment faible, c'est-à-dire lorsque la surface occupée par cette résistance est suffisamment faible, de l'ordre d'une dizaine ou de quelques dizaines de mm$^2$, une forme d'une seule pièce et présentant une symétrie par rapport à un axe reliant les attaches conductrices, de manière à éviter la formation de points chauds, est utilisée.

A titre d'exemple, la figure 3 représente une forme rectangulaire, et la figure 4 une forme trapézoïdale, les résistances étant respectivement désignées par 7 et 8, les attaches conductrices par 9, 10, 11 et 12 et ledit axe de symétrie étant repéré par Δ .

Lorsque la puissance électrique dissipée par une résistance est relativement élevée, c'est-à-dire lorsque la surface occupée par cette résistance est relativement élevée, pour fixer les idées de l'ordre du cm$^2$ ou plus, les formes représentées sur les figures 3 et 4 sont remplacées par une forme telle que représentée sur la figure 5.

Cette forme d'une résistance selon l'invention consiste en une association série-parallèle de résistances élémentaires de moindre surface telles que 13, 14, 15, obtenues chacune conformément à l'enseignement exposé ci-dessus et illustré par les figures 3 et 4.

A titre d'exemple d'une forme d'une résistance selon l'invention est représentée sur la figure 5 une association en série de quatre résistances formées chacune de trois résistances telles que 13, 14, 15 en parallèle. Les références 16, 17, 18, 19, 20 désignent des plages conductrices; les références telles que 21 et 22 désignent des plages isolantes.

Soit R la valeur de la résistance obtenue par cette association et r la valeur de chacune des résistances élémentaires telles que 13, 14, 15.

La valeur r vérifie alors la relation

$$r = \frac{3\,R}{4}$$

Les formes de résistances ainsi exposées à titre d'exemple en relation avec les figures 3, 4, 5 permettent d'obtenir une répartition uniforme de la puissance dissipée par ces résistances sur la surface occupée.

## Revendications

1. Résistance pour circuit hybride, notamment de puissance, obtenue par sérigraphie de matière résistive sur le substrat du circuit hybride, suivant un motif déterminé, ladite résistance étant formée par association en série de résistances (13, 14, 15) en parallèle, de manière à obtenir une répartition uniforme, sur sa surface, de la puissance dissipée par cette résistance.

## Patentansprüche

1. Widerstand für eine Hybridschaltung, insbesondere eine Leistungsschaltung, der durch serigraphische Bearbeitung eines Widerstandsmaterials auf dem Substrat der Hybridschaltung gemäß einem bestimmten Motiv erhalten wird, wobei dieser Widerstand durch eine Reihenanordnung von parallelen Widerständen (13, 14, 15) gebildet wird, so daß sich eine gleichmäßige Verteilung der von diesem Widerstand umgesetzten Leistung über die Oberfläche ergibt.

## Claims

1. Hybrid circuit resistor, in particular high-power resistor, manufactured by silkscreening resistive material onto the hybrid circuit substrate, in a specific pattern, said resistor being formed by the series combination of resistors (13, 14, 15) in parallel in such a way as to obtain a uniform distribution over its surface of the power dissipated by said resistor.

FIG.1

FIG.2

FIG.3

FIG.5

FIG.4